# EUROPEAN PATENT SPECIFICATION

(11) **EP 0 747 945 B1**
(45) Date of publication and mention of the grant of the patent: **29.12.2004**
(21) Application number: 96304024.1
(22) Date of filing: 04.06.1996
(51) Int. Cl.: H01L 21/66

(54) **Wafer orientation inspection system**
Scheibenorientierungsinspektionssystem
Système d'inspection d'orientation de tranche

(30) Priority: 07.06.1995 US 475232; 07.06.1995 US 475234
(43) Date of publication of application: 11.12.1996
(73) Proprietor: Varian Semiconductor Equipment Associates Inc., Gloucester, MA 01930 (US)
(72) Inventor: Landau, Richard F., Mountain View, California 94040 (US); Schultheis, Edward D., Mountain View, California 94040 (US)
(74) Representative: Cline, Roger Ledlie

(56) References cited:
- EP-A- 0 288 233
- US-A- 4 644 172
- US-A- 4 833 790
- US-A- 5 281 320

## Description

The present invention relates generally to wafer handling systems, and more particularly to a system of calibrating a wafer transfer arm and monitoring the orientation of wafers throughout their transfer between areas within a wafer processing system.

Multiple station wafer processing systems are an integral part of the manufacture of integrated circuits and other wafer based products. These systems typically have multiple coating stations which allow a variety of materials to be deposited on the wafer surface. Patterning and etching stations may be interspersed between the coating stations.

A single system with multiple processing stations offers a number of benefits over the use of separate processing systems for each stage of production. First, wafer fabrication in a multiple station system is much faster than that obtainable using individual processing systems since the wafers need not be pretreated between each station and the overall system can be easily automated. Second, a superior product can be fabricated using such a system since the wafers do not become contaminated between production steps. Contamination results not just from airborne contaminants, but also from such sources as water vapor. Therefore it is critical to keep the wafers in an evacuated environment throughout as much of the process as possible. In a multiple station system even during wafer transfer the wafers are never exposed to pressures greater than approximately 6.6 x 10^{-6 Pa}.

Multiple station wafer handling systems typically use robotic transfer arms to move wafers from station to station. These transfer arms must be calibrated so that they place the wafers in the correct position within each processing station. If a wafer is not properly placed within a station it may be improperly treated, thus leading to a defective part. Furthermore, this defect may not be readily apparent and thus substantial and costly processing and testing may be completed before the defect is even identified. To further exacerbate the problem, once the transfer arm is out of calibration tens or hundreds of wafers may be processed before the defect is even noticed thus leading to even greater financial loss.

Once it is determined that the transfer arm must be calibrated, the entire handling system must be brought up to atmospheric pressure and the system taken apart to a sufficient degree to enable a technician to calibrate the arm. The arm is calibrated by moving it to each processing station and visually inspecting its location. Based upon this visual inspection, the arm is adjusted and the inspection process is repeated. This procedure continues until the system user is satisfied with the arm's calibration, at which time the system is reassembled and evacuated. Assuming that only minor transfer arm adjustment and calibration are required, this procedure typically requires approximately 16-20 hours. Furthermore the final calibration is not very accurate since it is based solely on a visual review of the placement of the transfer arm within each processing station.

Wafers are often selected for processing on the basis of their crystallographic orientation. This orientation is typically noted on each individual wafer through the placement of a notch or a flat along the wafer's circumference. Therefore it is often important that the wafer handling system have some means of identifying the orientation of each wafer as well as maintaining the proper alignment of the wafers throughout processing.

Presently wafer orientation is determined using a costly laser system. The laser scans each wafer to determine its orientation, and then the wafer is rotated to achieve the desired alignment of the wafer's orientation with respect to the processing system. Once the wafer's orientation is properly aligned, the user must simply assume that the wafer does not become misaligned during subsequent handling and processing. A wafer which becomes misaligned during processing may not meet the required operational specifications, thus leading to its rejection. Further wafer orientation systems are disclosed in US 528/320 and EP 288 233.

From the foregoing, it is apparent that a method of calibrating the transfer arm in a multiple station processing system without breaking system vacuum or incurring a long system downtime is desirable. Furthermore, an easy method of aligning and maintaining the alignment of the wafers during processing is also desired.

The invention is alternatively set out in claims 1 and 9. Features suitable for inclusion in subsidiary claims are set out in the following four paragraphs.

In one aspect of the invention, a reticle is mounted in the wafer transfer arm and a locator mark is placed at a known position within each processing station. When the transfer arm is placed in a "calibration" position, the locator will be coincident with a known position on the reticle only if the transfer arm is properly calibrated. An image of the reticle with the superimposed locator mark is optically relayed to the user. If the transfer arm is not within calibration tolerances, the user can remotely adjust the transfer arm to bring it to within specifications. The system can also be automated so it routinely checks the calibration of the transfer arm and makes adjustments as necessary.

In a specific embodiment of the invention, the image of the reticle and the locator mark are relayed via fiber optics to a video camera assembly. The picture of the reticle and the superimposed locator mark are viewed in real time by a system operator who makes the necessary transfer arm adjustments. If the system is operating within calibration tolerances, the operator can make a permanent record of the system's performance. The data from the camera assembly can also be digitized and used to automatically adjust the position of the transfer arm.

In another aspect of the invention, the system includes a video camera which is used to observe the orientation markings on each wafer as it is removed from the system loading cassette and readied for processing. The system also includes means to rotate each wafer until its crystallographic orientation is properly positioned. This system can be used manually or it can be fully automated.

In another aspect of the invention, a wafer orientation monitoring system is mounted immediately adjacent to each individual processing station. Each monitoring system uses a video camera to observe the orientation markings on each wafer as the wafer is being transferred from the prior station to the present station. Since the wafer transfer operation does not have to be stopped during orientation monitoring, the overall system speed is not affected. In operation, as the wafer passes below the video camera an image of the wafer and hence its orientation markings are digitized. This digital image is then compared to data stored within the system. As long as the alignment of the wafer is such that its orientation is within the tolerance specification, the processing continues. If the wafer's orientation is incorrect, wafer identification data are noted so that the wafer can be subsequently rejected. In an alternate embodiment, the system is programmed to send the misoriented wafer back to the wafer orientation module for realignment.

Examples of the prior art and of the invention will now be described with reference to the accompanying drawings.
Fig. 1 is an illustration of a cross-sectional view of a conventional multiple station wafer processing system;
Fig. 2 is an illustration of a wafer which has a notch to indicate the wafer's crystallographic orientation;
Fig. 3 is an illustration of a wafer which has a flat along the wafer's circumference to indicate its crystallographic orientation;
Fig. 4 is a simplified illustration of a processing system which includes one aspect of the invention;
Fig. 5 is an illustration of the processing system shown in Fig. 4 with the transfer arms withdrawn from the processing station;
Fig. 6 is an illustration of a standard two prong transfer arm which has been modified to include the remote position sensing assembly of the present invention;
Fig. 7 is an illustration of the cross-section of a transfer arm highlighting the remote position sensing assembly;
Fig. 8 is an illustration of a reticle suitable for use with the invention;
Fig. 9 is an illustration of the reticle of Fig. 8 with the locator mark superimposed at its center;
Fig. 10 is an illustration of the center prism assembly;
Fig. 11 is an illustration of the camera assembly used with the remote position sensing assembly;
Fig. 12 is an illustration of the wafer orienting aspect of the invention;
Fig. 13 is an illustration of the screen of a CRT display showing an improperly oriented wafer and the outline of a correctly oriented wafer;
Fig. 14 is an illustration of a multiple station wafer processing system with a plurality of windows positioned immediately adjacent to the entrance of each processing station; and
Fig. 15 is an illustration of a cross-sectional view of a wafer orientation monitoring system mounted immediately adjacent to each processing station.

### DESCRIPTION OF SPECIFIC EMBODIMENTS

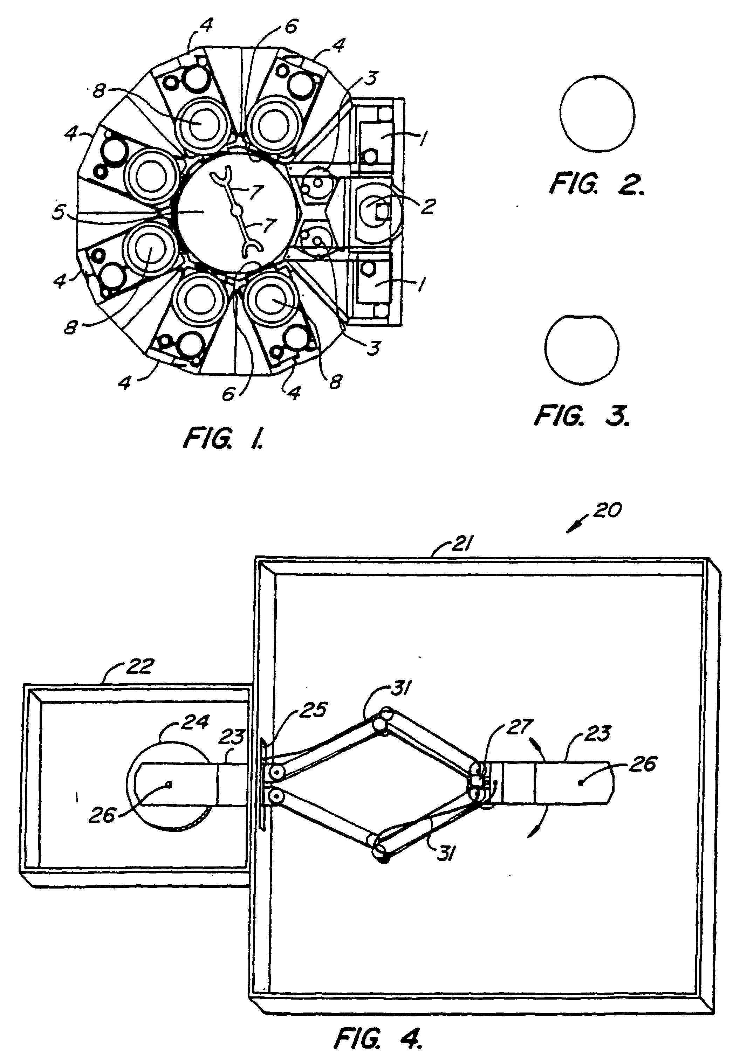

Fig. 1 is an illustration of a cross-sectional view of a conventional multiple station wafer processing system. Areas 1 are for loading and unloading wafer cassettes. If necessary, each individual wafer can be rotated at a rotation stage 2 in order to properly align the wafer's crystallographic orientation. In a conventional system, the orientation of the wafer is determined using a laser scanning system (not shown). The orientation of the wafer is determined on the basis of physical markings such as a notch (as illustrated in Fig. 2) or a flat (as illustrated in Fig. 3). After alignment, the wafer is transferred to a degassing station 3. From station 3, the wafer is transferred to any one of several processing stations 4. Each processing station 4 is separated from the transfer module 5 by a valve 6, thus allowing individual stations to operate at different pressures than that maintained in the transfer module. Wafers are transferred between stations with an extendable robotic transfer arm 7. The system has two arms 7 in order to increase wafer throughput speed. When properly calibrated, transfer arms 7 place wafers at the center of zone 8 within each station 4.

In the conventional system shown in Fig. 1, when transfer arms 7 require calibration the entire system must first be brought to atmospheric pressure. Next the covers must be removed from transfer module 5 as well as each of the processing stations 4. To perform the actual calibration, transfer arm 7 is extended into one of the processing stations 4 as if it were delivering a wafer. A system operator then visually inspects the position of transfer arm 7 in relation to zone 8. This inspection process is performed in each station 4 to determine how to properly adjust arm 7. After adjustment, the procedure is typically repeated at least one more time to insure that transfer arm 7 is now properly calibrated. After calibration, transfer module 5 as well as each processing station 4 must be reassembled and the entire system evacuated. The calibration process, from start to finish, generally takes between 16 and 20 hours.

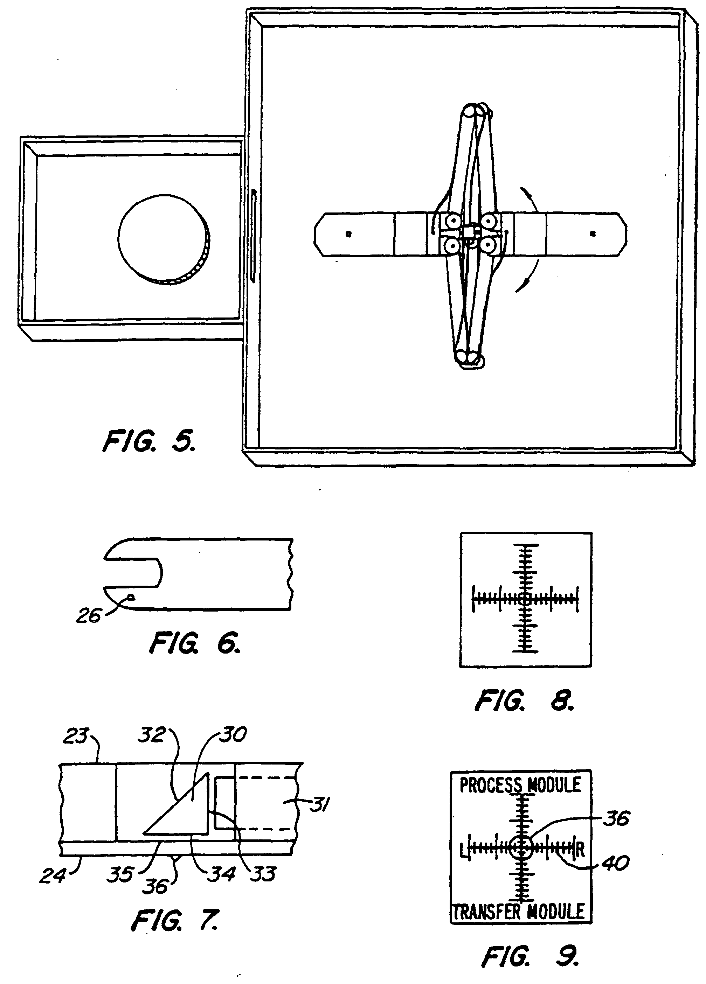

Fig. 4 is a simplified illustration of a processing system 20 which has been modified to include one aspect of the present invention. System 20 is comprised of a transfer module 21 and a processing station 22. Also shown is a pair of transfer arms 23, one in an extended position. In the extended position the transfer arm can either be delivering a wafer for processing or, as illustrated in Fig. 4, the arm can be empty in preparation for calibration. Contained within processing station 22 is a process pedestal 24. Under normal processing conditions a wafer is placed on pedestal 24 by arm 23, arm 23 is withdrawn from processing station 23 (as illustrated in Fig. 5), a valve (not shown) closes off station 22 at an access port 25, the system undergoes further evacuation and the wafer is processed (for example, coated with a specific material).

Located within transfer arm 23 is a remote position sensing assembly 26. A fiber optic cable 31 relays position information from assembly 26 to a center prism assembly 27.

In the embodiment shown, assembly 26 is centered in the transfer arm such that it is coincident with the center of processing pedestal 24. However, assembly 26 can also be placed in one of the prongs of a standard transfer arm configuration as illustrated in Fig. 6, or elsewhere.

Fig. 7 is an illustration of the cross-section of transfer arm 23 at the site of sensing assembly 26. In this embodiment, assembly 26 uses a prism 30 coupled to fiber optic cable 31 to direct an image of a portion of processing pedestal 24 to a remote viewer. For optimum efficiency, prism 30 has a reflective coating applied to the inside hypotenuse face 32 and anti-reflective coatings applied to right angle faces 33 and 34. Anti-reflective coatings are also applied to the endfaces of fiber optic cable 31. Prism 30 can be replaced with a simple mirror, although the prism is preferable due to its stability at elevated temperatures as well as the ease by which it can be mounted and maintained at the proper angle. A reticle 40, such as the one illustrated in Fig. 8, is either attached to a window 35 mounted to arm 23 beneath sensing assembly 26 or attached directly to prism face 34. In the preferred embodiment, reticle 40 is etched into window 35, reticle 40 containing calibrated cross hairs so that a user can accurately determine to what degree transfer arm 23 must be repositioned in order that it be properly aligned.

Process pedestal 24 contains a locator mark 36. Locator mark 36 is a dimple on the face of pedestal 24 in the preferred embodiment although it can be an etch mark or any other form of indicator mark which does not adversely affect pedestal 24's performance during normal wafer processing. When the system is properly aligned locator mark 36 lies directly beneath the center of reticle 40 when transfer arm 23 is in the calibration position, as illustrated in Fig. 9.

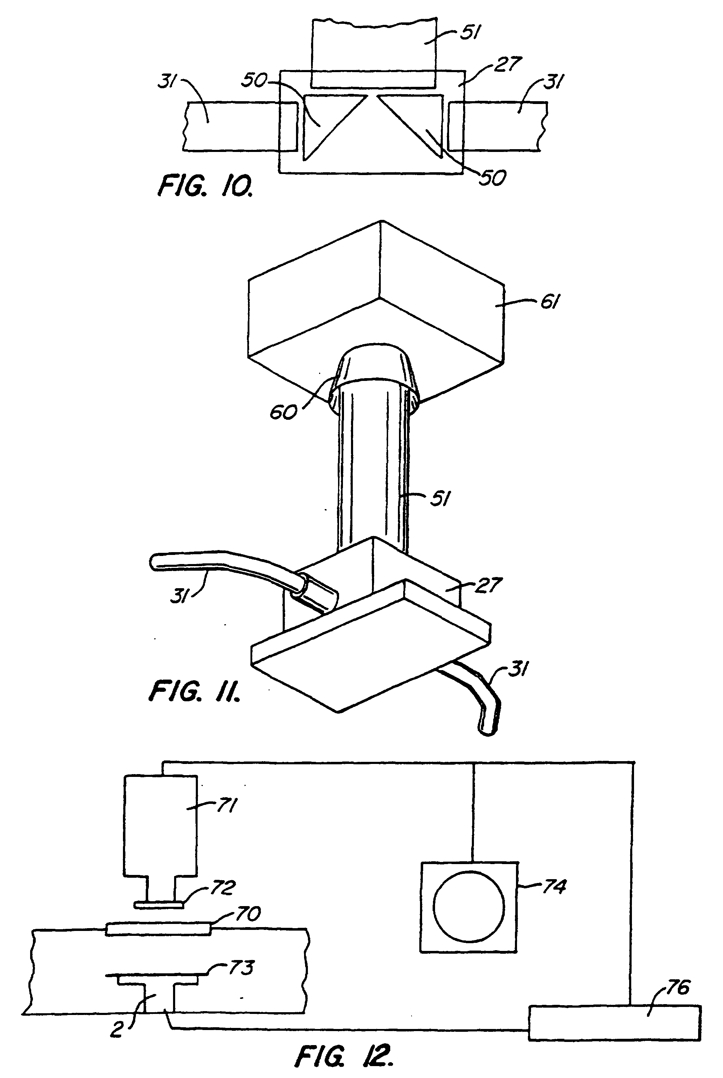

In the preferred embodiment, fiber optic cable 31 relays the image of reticle 40 with locator mark 36 superimposed on the image of reticle 40 to center prism assembly 27. As illustrated in Fig. 10, center prism assembly 27 contains two prisms 50 which couple the image from each fiber optic cable 31 to a single fiber optic rod 51. Prisms 50 have the same coatings as prism 30 and can similarly be replaced with simple turning mirrors. Rod 51 passes through the top surface of transfer module 21 (not shown). Although prism assembly 27 rotates with the rotation of transfer arms 23, rod 51 remains fixed with respect to transfer module 21.

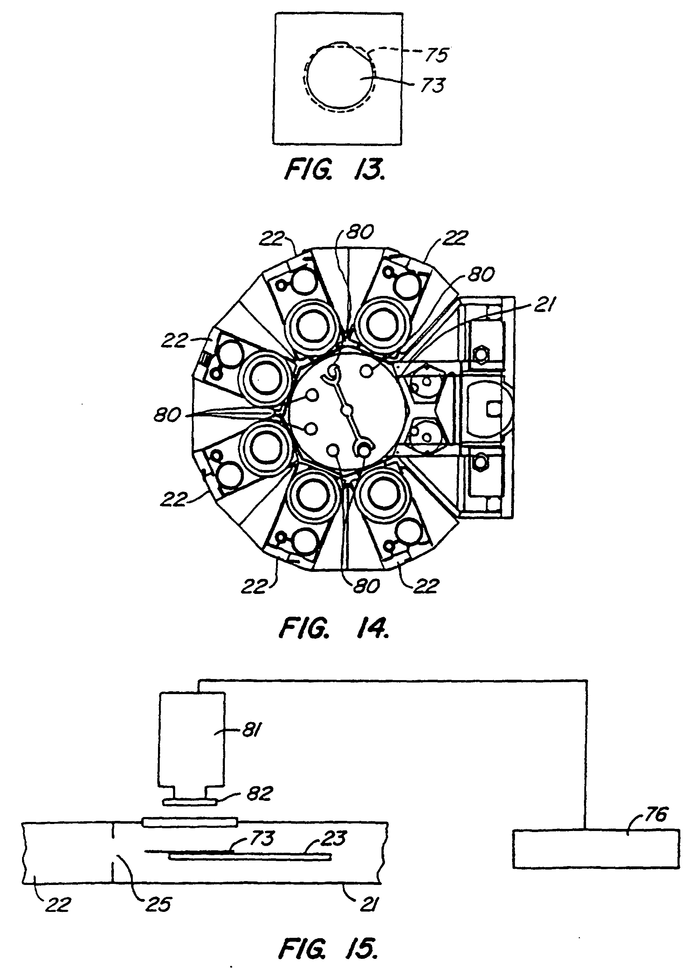

Fig. 11 is an illustration of the camera assembly. After passing through the top surface of transfer module 21 (not shown), fiber optic rod 51 is coupled to a lens assembly 60 of a video camera 61. The video camera records the images of reticles 40 and associated locator marks 36 for each transfer arm 23.

In the preferred embodiment, the calibration data received by camera assembly 61 are digitized and sent to a CRT screen for review by the system operator. Based upon this information, the system operator remotely adjusts the position of transfer arms 23 until they are correctly aligned. In an alternate embodiment, the digitized data from camera assembly 61 is used by a computer to perform an automatic adjustment of the transfer arms' positions.

In an alternate embodiment, fiber optic cables 31 and fiber optic rod 51 are replaced with a series of relay mirrors. The image passes through a window mounted in the top surface of transfer module 21 where it is recorded by camera 61.

In another aspect of the invention shown in Fig. 12, a window 70 is mounted in the top surface of the multiple wafer processing system directly above rotation stage 2. Mounted directly above this window is a video camera 71 with a wide angle lens 72. After a wafer 73 is placed on rotation stage 2, an image of the wafer is recorded by camera 71, digitized, and sent to a CRT 74. In one embodiment, superimposed on the image of wafer 73 is an image of the outline of a correctly aligned wafer. A user can then rotate stage 2 until the image of wafer 73 is coincident with the outline of the correctly aligned wafer. Fig. 13 is an illustration of CRT 74's screen with an image of wafer 73 as well as an outline of a correctly aligned wafer 75.

In another embodiment of the invention, the digitized data from camera 71 is sent to a computer which determines whether wafer 73 is correctly aligned and if not, by how much it is out of alignment. Computer 76 then rotates stage 2 until wafer 73 should be properly aligned, and then rechecks the orientation of wafer 73 to insure that it is within alignment tolerances. Comparison algorithms suitable for this task are well known by those skilled in the art.

In another aspect of the invention illustrated in Fig. 14, a plurality of windows 80 are placed in the top surface of transfer module 21, each window 80 placed immediately adjacent to the entrance of each processing station 22. Fig. 15 is a cross-sectional view of this aspect of the invention. Mounted directly above each window 80 is a video camera 81 with a wide angle lens 82. As transfer arm 23 moves a wafer 73 into processing station 22 through access port 25, an image of wafer 73 is recorded and digitized by camera 81 and sent to computer 76. Computer 76 determines whether or not wafer 73 is correctly aligned as it is entering station 22. In the preferred embodiment, if wafer 73 is not within the designated orientation tolerances, computer 76 records the wafer's identification data so that it may be easily rejected at a later time. In an alternate embodiment, computer 76 temporarily stops the processing of wafer 73 and transfers it back to stage 2 for realignment. After the wafer's alignment is corrected, the processing of this wafer is resumed.

## Claims

1. A method of inspecting a crystallographic orientation of a wafer in a sealable semiconductor processing system, said method comprising the steps of:
detecting said crystallographic orientation of said wafer while said system is sealed; and
determining whether said crystallographic orientation of said wafer matches a preselected crystallographic orientation.

2. A method as claimed in claim 1 wherein said detecting step further comprises the step of remotely imaging said wafer with a video camera.

3. A method as claimed in claim 2 wherein the wafer is supported on a rotation stage the method comprising rotating said stage until said crystallographic orientation of said wafer is aligned with a preselected crystallographic orientation.

4. A method as claimed in claim 2 or claim 3 further comprising the step of communicating said video camera image of said wafer to a display.

5. A method as claimed in any one of the preceding claims further comprising the step of aligning said crystallographic orientation of said wafer with said preselected crystallographic orientation.

6. A method as claimed in any one of claims 2 to 4, said remote imaging step further comprising the step of communicating said image of said wafer to a computer, said computer determining said crystallographic orientation of said wafer.

7. A method as claimed in claim 5 and claim 6 wherein the aligning is performed in response to said computer.

8. A method as claimed in any one of the preceding claims wherein the detecting step is performed as said wafer is transferred from a first location to a second location in said sealable semiconductor processing system.

9. A wafer orientation inspection system for inspecting a crystallographic orientation of a wafer, said wafer within a sealable semiconductor processing system, said inspection system comprising:
an orientation sensing system, wherein said sensing system determines said orientation of said wafer in said sealable semiconductor processing system while said processing system is sealed; and a comparator for determining if said crystallographic orientation of said wafer matches a preselected crystallographic orientation.

10. A system as claimed in claim 9 wherein said sensing system determines said orientation of said wafer while said wafer is transferred along a transfer path from a first location to a second location.

11. A system as claimed in claim 10, said orientation sensing system further comprising a video camera mounted in a site adjacent to said transfer path for said wafer, said site of said camera allowing said camera to view said wafer as it is transferred from said first location to said second location.

12. A system as claimed in claim 11 further comprising a display coupled to said video camera, said display communicating said crystallographic orientation of said wafer.

13. A system as claimed in claim 11 or claim 12 further comprising a wide angle lens coupled to said video camera.

14. A system as claimed in any one of claims 10 to 13 comprising a wafer rotation stage within said sealable semiconductor processing system, for transferring the wafer along said transfer path and a controller for remotely rotating said wafer rotation stage while said sealable semiconductor processing system is sealed.

15. A system as claimed in claim 14 wherein said comparator is arranged to cause the wafer rotation stage to rotate until said crystallographic orientation of said wafer is aligned with a preselected crystallographic orientation.

16. A system as claimed in any one of claims 9 to 14 wherein said comparator records an identification data for said wafer if said crystallographic orientation of said wafer does not match said preselected crystallographic orientation.

17. A system as claimed in any one of claims 9 to 16 wherein said sealable semiconductor processing system is a sputtering system.

## Patentansprüche

1. Verfahren zur Prüfung einer kristallographischen Orientierung eines Wafers in einem abdichtbaren Halbleiterbearbeitungssystem, wobei das Verfahren die folgenden Schritte umfaßt:
Detektieren der kristallographischen Orientierung des Wafers, während das System abgedichtet wird;
Bestimmen, ob die kristallographische Orientierung des Wafers einer vorgewählten kristallographischen Orientierung entspricht.

2. Verfahren nach Anspruch 1, wobei der Detektierungsschritt weiterhin den Schritt des entfernten Abbildens des Wafers mit einer Videokamera umfaßt.

3. Verfahren nach Anspruch 2, wobei der Wafer auf einem Drehtisch gestützt wird, wobei das Verfahren das Drehen des Tischs umfaßt, bis die kristallographische Orientierung des Wafers auf eine vorgewählte kristallographische Orientierung ausgerichtet ist.

4. Verfahren nach Anspruch 2 oder 3, weiterhin mit dem Schritt des Schickens des Videokamerabilds des Wafers an ein Display.

5. Verfahren nach einem der vorhergehenden Ansprüche, weiterhin mit dem Schritt des Ausrichtens der kristallographischen Orientierung des Wafers auf die vorgewählte kristallographische Orientierung.

6. Verfahren nach einem der Ansprüche 2-4, wobei der Schritt des entfernten Abbildens weiterhin den Schritt des Sendens des Bilds des Wafers an einen Computer umfaßt, wobei der Computer die kristallographische Orientierung des Wafers bestimmt.

7. Verfahren nach Anspruch 5 und 6, wobei das Ausrichten als Reaktion auf den Computer durchgeführt wird.

8. Verfahren nach einem der vorhergehenden Ansprüche, wobei der Detektierungsschritt durchgeführt wird, während der Wafer von einer ersten Stelle zu einer zweiten Stelle in dem abdichtbaren Halbleiterbearbeitungssystem übertragen wird.

9. Waferorientierungsprüfsystem zum Prüfen einer kristallographischen Orientierung eines Wafers, wobei sich der Wafer innerhalb eines abdichtbaren Halbleiterbearbeitungssystems befindet, wobei das Prüfsystem folgendes umfaßt:
ein Orientierungsmeßsystem, wobei das Meßsystem die Orientierung des Wafers in dem abdichtbaren Halbleiterbearbeitungssystem bestimmt, während das Bearbeitungssystem abgedichtet wird; und einen Vergleicher zum Bestimmen, ob die kristallographische Orientierung des Wafers einer vorgewählten kristallographischen Orientierung entspricht.

10. System nach Anspruch 9, wobei das Meßsystem die Orientierung des Wafers bestimmt, während der Wafer entlang einem Übertragungsweg von einer ersten Stelle zu einer zweiten Stelle übertragen wird.

11. System nach Anspruch 10, wobei das Orientierungsmeßsystem weiterhin eine Videokamera umfaßt, die an einem Ort neben dem Übertragungsweg für den Wafer montiert ist, wobei der Ort der Kamera gestattet, daß die Kamera den Wafer betrachtet, während er von der ersten Stelle zu der zweiten Stelle übertragen wird.

12. System nach Anspruch 11, weiterhin mit einem an die Videokamera gekoppelten Display, wobei das Display die kristallographische Orientierung des Wafers meldet.

13. System nach Anspruch 11 oder 12, weiterhin mit einer an die Videokamera gekoppelten Weitwinkellinse.

14. System nach einem der Ansprüche 10-13, mit einem Waferdrehtisch innerhalb des abdichtbaren Halbleiterbearbeitungssystems zum Übertragen des Wafers entlang dem Übertragungsweg und eine Steuerung zum entfernten Drehen des Waferdrehtischs, während das abdichtbare Halbleiterbearbeitungssystem abgedichtet wird.

15. System nach Anspruch 14, wobei der Vergleicher so ausgelegt ist, daß er bewirkt, daß sich der Waferdrehtisch dreht, bis die kristallographische Orientierung des Wafers auf eine vorgewählte kristallographische Orientierung ausgerichtet ist.

16. System nach einem der Ansprüche 9-14, wobei der Vergleicher Identifikationsdaten für den Wafer aufzeichnet, falls die kristallographische Orientierung des Wafers nicht der vorgewählten kristallographischen Orientierung entspricht.

17. System nach einem der Ansprüche 9-16, wobei das abdichtbare Halbleiterbearbeitungssystem ein Sputtersystem ist.

## Revendications

1. Procédé d'inspection d'une orientation cristallographique d'une plaquette dans un système de fabrication de composants à semiconducteur susceptible d'être rendu hermétique, ledit procédé comprenant les étapes de :
détection de ladite orientation cristallographique de ladite plaquette pendant que ledit système est hermétique ; et
détermination quant à savoir si ladite orientation cristallographique de ladite plaquette correspond à une orientation cristallographique présélectionnée.

2. Procédé selon la revendication 1, dans lequel ladite étape de détection comprend en outre l'étape de formation à distance d'une image de ladite plaquette à l'aide d'une caméra vidéo.

3. Procédé selon la revendication 2, dans lequel la plaquette est supportée sur un étage de rotation, le procédé comprenant la rotation dudit étage jusqu'à ce que ladite orientation cristallographique de ladite plaquette soit alignée sur une orientation cristallographique présélectionnée.

4. Procédé selon la revendication 2 ou la revendication 3, comprenant en outre l'étape de transmission de ladite image de ladite plaquette par la caméra vidéo à un affichage.

5. Procédé selon l'une quelconque des revendications précédentes, comprenant en outre l'étape d'alignement de ladite orientation cristallographique de ladite plaquette sur ladite orientation cristallographique présélectionnée.

6. Procédé selon l'une quelconque des revendications 2 à 4, ladite étape de formation à distance d'une image comprenant en outre l'étape de transmission de ladite image de ladite plaquette à un ordinateur, ledit ordinateur déterminant ladite orientation cristallographique de ladite plaquette.

7. Procédé selon la revendication 5 et la revendication 6, dans lequel l'alignement s'effectue en réponse audit ordinateur.

8. Procédé selon l'une quelconque des revendications précédentes, dans lequel l'étape de détection s'effectue lors du transfert de ladite plaquette d'un premier emplacement à un deuxième emplacement dans ledit système de fabrication de composants à semiconducteur susceptible d'être rendu hermétique.

9. Système d'inspection de l'orientation d'une plaquette pour l'inspection d'une orientation cristallographique d'une plaquette, ladite plaquette se trouvant à l'intérieur d'un système de fabrication de composants à semiconducteur susceptible d'être rendu hermétique, ledit système d'inspection comprenant :
un système de détection de l'orientation, ledit système de détection déterminant ladite orientation de ladite plaquette dans ledit système de fabrication de composants à semiconducteur susceptible d'être rendu hermétique pendant que ledit système de fabrication est hermétique ; et
un comparateur pour déterminer si ladite orientation cristallographique de ladite plaquette correspond à une orientation cristallographique présélectionnée.

10. Système selon la revendication 9, dans lequel ledit système de détection détermine ladite orientation de ladite plaquette lors du transfert de ladite plaquette le long d'un trajet de transfert d'un premier emplacement à un deuxième emplacement.

11. Système selon la revendication 10, ledit système de détection de l'orientation comprenant en outre une caméra vidéo montée en une position adjacente audit trajet de transfert de ladite plaquette, ladite position de ladite caméra permettant à ladite caméra de voir ladite plaquette lors de son transfert dudit premier emplacement audit deuxième emplacement.

12. Système selon la revendication 11, comprenant en outre un affichage couplé à ladite caméra vidéo, ledit affichage transmettant ladite orientation cristallographique de ladite plaquette.

13. Système selon la revendication 11 ou la revendication 12, comprenant en outre un objectif grand-angulaire couplé à ladite caméra vidéo.

14. Système selon l'une quelconque des revendications 10 à 13, comprenant un étage de rotation de plaquette à l'intérieur dudit système de fabrication de composants à semiconducteur susceptible d'être rendu hermétique, pour transférer la plaquette le long dudit trajet de transfert, et une unité de commande pour effectuer la rotation à distance dudit étage de rotation de plaquette pendant que ledit système de fabrication de composants à semiconducteur susceptible d'être rendu hermétique est hermétique.

15. Système selon la revendication 14, dans lequel ledit comparateur est conçu pour entraîner en rotation l'étage de rotation de plaquette jusqu'à ce que ladite orientation cristallographique de ladite plaquette soit alignée sur une orientation cristallographique présélectionnée.

16. Système selon l'une quelconque des revendications 9 à 14, dans lequel ledit comparateur enregistre une donnée d'identification pour ladite plaquette si ladite orientation cristallographique de ladite plaquette ne correspond pas à ladite orientation cristallographique présélectionnée.

17. Système selon l'une quelconque des revendications 9 à 16, dans lequel ledit système de fabrication de composants à semiconducteur susceptible d'être rendu hermétique est un système à pulvérisation cathodique.
